(19) Europäisches Patentamt

European Patent Office

Office européen des brevets

(11) **EP 0 892 859 B1**

(12) **EUROPÄISCHE PATENTSCHRIFT**

(45) Veröffentlichungstag und Bekanntmachung des Hinweises auf die Patenterteilung:
**03.11.1999 Patentblatt 1999/44**

(21) Anmeldenummer: 97920530.9

(22) Anmeldetag: 14.03.1997

(51) Int Cl.6: **C23C 14/06**, C30B 31/22

(86) Internationale Anmeldenummer:
**PCT/DE97/00568**

(87) Internationale Veröffentlichungsnummer:
**WO 97/34022 (18.09.1997 Gazette 1997/40)**

(54) **VERFAHREN ZUR HERSTELLUNG ENDOHEDRALER FULLERENE ODER FULLERENDERIVATE**

PROCESS FOR PREPARING ENDOHEDRAL FULLERENES OR FULLERENE DERIVATIVES

PROCEDE DE PREPARATION DE FULLERENES ENDOHEDRALES OU DE DERIVES DE FULLERENE

(84) Benannte Vertragsstaaten:
**AT BE CH DE DK ES FI FR GB GR IE IT LI LU MC NL PT SE**

(30) Priorität: **14.03.1996 DE 19611771**

(43) Veröffentlichungstag der Anmeldung:
**27.01.1999 Patentblatt 1999/04**

(73) Patentinhaber: **Forschungsverbund Berlin e.V.
12489 Berlin (DE)**

(72) Erfinder:
- **CAMPBELL, Eleanor
  D-14109 Berlin (DE)**
- **HERTEL, Ingolf
  D-14129 Berlin (DE)**
- **TELLGMANN, Ralf
  D-10961 Berlin (DE)**

(74) Vertreter: **Rudolph, Margit et al
Heinrich-Hertz-Institut für Nachrichtentechnik
Berlin GmbH,
Gemeinsamer Patentservice,
Hausvogteiplatz 5-7
10117 Berlin (DE)**

(56) Entgegenhaltungen:
**EP-A- 0 538 797          EP-A- 0 667 317**

- **SYNTHETIC MATERIALS, Bd. 73, Nr. 2, 1.August 1995, CH, Seite 145-149 XP002034634 TROUILLAS: "doping effects induced by potassium ion implantation in solid C60"**
- **PATENT ABSTRACTS OF JAPAN vol. 18, no. 533 (C-1259), 11.Oktober 1994 & JP 06 184738 A (MITSUBISHI ELECTRIC CORP.), 5.Juli 1994,**
- **MATERIALS SCIENCE AND ENGINEERING B, Bd. b19, Nr. 1/2, 19.April 1993, LAUSANNE CH, Seiten 117-121, XP000361659 TAKAHASI : "photoemission study of superconductive and non-superconductive alkali-doped C60 and C70 "**

## Beschreibung

Die Erfindung betrifft ein Verfahren zur Herstellung endohedraler Fullerene oder Fullerenderivate aus vorgefertigten Fullerenen bzw. Fullerenderivaten.

Seit der erstmaligen labormäßigen Herstellung von Fullerenen im Jahre 1990, deren Existenz schon Jahre vorher vorausgesagt wurden, konnten grundlegende Ergebnisse bei der Erforschung dieser Kohlenstoffstruktur vermeldet werden.

Fullerene sind käfig- oder röhrenförmige Hohlmolekülstrukturen, die aus mindestens 20 und bis zu über 1000 Kohlenstoffatomen zusammengesetzt sind. Fullerenderivate sind chemisch modifizierte Fullerene, bei denen ein oder mehrere Kohlenstoffatome durch Atome oder Moleküle anderer Elemente ersetzt oder die Käfigatome mit Atomen oder Molekülen anderer Elemente chemisch verbunden sind. Hierzu zählen auch Polymere aus Fullerenen oder molekulare Verbindungen mit Fullerenen.

Besonders interessant für technische Anwendungen ist die gezielte Änderung der Struktur und damit die gezielte Beeinflussung der Eigenschaften der Fullerene, insbesondere der elektrischen Eigenschaften, beispielsweise durch Einschluß mindestens eines oder mehrerer Fremdatome oder Moleküle in die Käfigstruktur der Fullerene bzw. Fullerenderivate. Solche Strukturen werden als endohedrale Fullerene bzw. Fullerenderivate bezeichnet und durch das chemische Symbol $M@C_n$ beschrieben, wobei M das eingeschlossene Atom oder Molekül symbolisiert und n die Anzahl der in der Käfigstruktur enthaltenen Kohlenstoffatome bedeutet.

Endohedrale Fullerene können im Krätschmer-Huffman-Lichtbogenverfahren (NATURE, VOL 347, 27 SEPT. 1990, 354 - 358), das üblicherweise zur Herstellung reiner Fullerene benutzt wird, durch Zugabe von Metalloxiden oder -salzen zu den verwendeten Graphitstäben erzeugt werden. Hierbei bildet sich ein Gemisch von Fullerenen und endohedralen Fullerenen aus den Ausgangsatomen. Dies führt beispielsweise zu makroskopisch isolierbarem $M@C_{82}$, wobei M ein Element der dritten Gruppe (La, Sc, Y) oder der Lanthanide ist (NATURE, VOL 366, 11 NOV. 1993, 123 - 128). Die Ausbeute - bezogen auf die gleichzeitig hergestellte Menge von Fullerenen und Fullerenderivaten - liegt jedoch deutlich unter 1 %. Außerdem werden gleichzeitig erhebliche Mengen Ruß erzeugt, von dem Fullerene und endohedrale Fullerene zunächst getrennt werden müssen.

Auch mit Hilfe der sogenannten "Smalley-Quelle" können endohedrale Fullerene hergestellt werden (J. Phys. Chem., Vol. 95, No. 20, 7564-7568 (1991)). Hierbei werden mittels eines gepulsten Lasers Graphit-Lanthanoxid-Stäbe verdampft. Der Dampf dieser Verbindung wird von einem darüber geleiteten Argonstrom bei 1200°C mitgerissen. Bei der Expansion ins Vakuum kühlen die Atome ab, kondensieren und bilden endohedrale Fullerene der Form $La@C_n$, wobei n = 60, 70, 74, 82 ist. Auch hier ist die Ausbeute noch sehr gering und werden erhebliche Rußbeimengungen erzeugt.

In SCIENCE, VOL. 259, 5 MARCH 1993, 1428 - 1430 ist die Herstellung endohedraler Fullerene der Form $Rg@C_n$ (Rg symbolisiert ein Edelgasatom) beschrieben. $Rg@C_n$ wird aus Fullerenpulver gebildet, das einer Edelgasatmosphäre bei hohem Druck (2500 atm) und hohen Temperaturen (ca. 600 °C) ausgesetzt ist. Die Ausbeute dieses Verfahrens, das nur auf Edelgase anwendbar ist, beträgt ca. 0,3 % des eingesetzten $C_{60}$.

Einzelne endohedrale Fullerenmolekülionen können beim Stoß von Fullerenmolekülen bzw. Fullerenmolekülionen mit Atomionen bzw. Atomen in der Gasphase gebildet werden (J. Chem. Phys. **99** (8), 15 Oct. 1993, 5858 - 5870). Für weiterführende Untersuchungen sind diese Mengen jedoch nicht ausreichend.

Bisher ist es also nicht gelungen, makroskopisch isolierbare Mengen endohedraler Fullerene bzw. Fullerenderivate auf effiziente und gleiche Art und Weise für eine Vielzahl von einzubauenden Dotanten herzustellen. Deshalb ist es Aufgabe der Erfindung, ein Verfahren anzugeben, das dies ermöglicht.

Diese Aufgabe wird erfindungsgemäß durch ein Verfahren gelöst, bei dem Fullerene oder Fullerenderivate auf ein Target aufgebracht und in der festen Phase mit niederenergetischen Ionen einer kinetischen Energie zwischen 5 eV und 500 eV der einzubauenden Dotanten bestrahlt werden.

Niederenergetische Ionenstrahlen sind im Rahmen der Erfindung Teilchenstrahlen geladener Atome oder Moleküle, die die angegebene kinetische Energie aufiveisen. Diese Atome oder Moleküle werden als Dotanten in die Fullerene bzw. Fullerenderivate eingebaut.

In Ausführungsformen ist vorgesehen, daß entweder zunächst ein Film von Fullerenen oder Fullerenderivaten auf ein Target aufgedampft und gleichzeitig die Dicke des aufgedampften Films gemessen wird, anschließend dieser Film definierter Dicke mit einem Ionenstrahl der einzubauenden Dotanten bestrahlt wird oder gleichzeitig sowohl Fullerene oder Fullerenderivate auf ein Target aufgedampft, als auch mit einem Ionenstrahl der einzubauenden Dotanten bestrahlt werden und die Dicke der aufgedampften und bestrahlten Schicht gemessen wird. Dabei weist die Bestrahlungsdosis und die über das an die Ionenquelle angelegte Potential regelbare Ionenenergie Werte auf, bei der die meisten Ionen der jeweiligen Dotanten in die Fullerene oder Fullerenderivate eingebaut werden. Besonders effektiv hat sich das Verfahren erwiesen, wenn bei nacheinander erfolgendem Aufdampfen eines Films von Fullerenen oder Fullerenderivaten und Bestrahlen dieses Films mit niederenergetischen Ionen diese Verfahrensschritte wiederholt werden.

Das erfindungsgemäße Verfahren wird in einer Vakuumapparatur bei einem Druck von < 1 mbar durchgeführt.

Neben dem Aufdampfen von Fullerenen auf ein Target kann das Aufbringen auch derart erfolgen, daß Fullerene oder Fullerenderivate in einem Lösungsmittel verdünnt, dann auf ein Target aufgespritzt und anschließend dem Ionenstrahl ausgesetzt werden.

Die kinetische Energie der auf die feste Phase der Fullerene oder Fullerenderivate auftreffenden Ionen ist über das an der Ionenquelle anliegende Potential regelbar und wird in Abhängigkeit von der Größe der Ionen und deren Wechselwirkung mit der bestrahlten Substanz so eingestellt, daß eine möglichst große Ausbeute der erwünschten endohedralen Fullerene oder Fullerenderivate erzielt wird, ohne dabei eine signifikante Zerstörung des Ausgangsmaterials zu bewirken.

So ist in anderen Ausführungsformen vorgesehen, in Meßreihen die Energie der Ionen und die Bestrahlungsdosis zu bestimmen, bei der die meisten Ionen der einzubauenden Dotanten in die Fullerene oder Fullerenderivate eindringen.

Diese optimierte Ionenenergie wird durch die Variation des an der Ionenquelle anliegenden Potentials derart ermittelt, daß zunächst für ein Potential der Ionenquelle der auf das Target fallende Ionenstrom gemessen wird, daraus die Bestrahlungsdosis (Anzahl der auftreffenden Ionen pro Fläche und Zeiteinheit) errechnet wird, danach das Verhältnis der Anzahl endohedraler Fullerene bzw. Fullerenderivate pro Fläche zur Anzahl der Fullerene bzw. Fullerenderivate pro Fläche bestimmt wird und dieses Verhältnis für verschiedene Potentiale der Ionenquelle bei konstanter Bestrahlungsdosis ermittelt wird und abschließend das Potential der Ionenquelle zur Bestrahlung der Fullerene oder Fullerenderivate ausgewählt wird, bei dem das Verhältnis der Anzahl endohedraler Fullerene bzw. Fullerenderivate pro Fläche zur Anzahl der Fullerene bzw. Fullerenderivate pro Fläche am größten ist.

Die Bestrahlungsdosis, bei der die meisten Ionen der jeweiligen Dotanten in die Fullerene oder Fullerenderivate eingeschlossen werden, wird derart bestimmt, daß durch Variation der Bestrahlungsdosis bei optimierter Ionenenergie das jeweilige Verhältnis der Anzahl endohedraler Fullerene bzw. Fullerenderivate pro Fläche zur Anzahl der Fullerene oder Fullerenderivate pro Fläche ermittelt wird und abschließend die Bestrahlungsdosis bei optimiertem Potential der Ionenquelle zur Bestrahlung der Fullerene oder Fullerenderivate ausgewählt wird, bei der das Verhältnis der Anzahl endohedraler Fullerene bzw. Fullerenderivate pro Fläche zur Anzahl der Fullerene bzw. Fullerenderivate pro Fläche am größten ist.

Das für die Bestimmung der optimierten Größen von Ionenenergie und Bestrahlungsdosis notwendige Verhältnis der Anzahl endohedraler Fullerene bzw. Fullerenderivate pro Fläche zur Anzahl der Fullerene oder Fullerenderivate pro Fläche kann mittels der Laserdesorptions-Massenspektroskopie ermittelt werden.

Das erfindungsgemäße Verfahren ermöglicht die Herstellung makroskopisch isolierbarer Mengen endohedraler Fullerene oder Fullerenderivate ohne erhebliche Rußbeimengungen und ist auf beliebige einzubauende Dotanten anwendbar. Die Ausbeute der mit dem erfindungsgemäßen Verfahren hergestellten endohedralen Fullerenen oder Fullerenderivaten liegt deutlich über den im Zusammenhang mit dem Stand der Technik veröffentlichten Werten. Mittels des erfindungsgemäßen Verfahrens werden beispielsweise unmittelbar Filme mit definierten Mengen von endohedralen Fullerenen oder Fullerenderivaten erzeugt, d.h. ein Umweg über ein aufwendiges Trennverfahren (HPLC) für die verschiedenen Fullerentypen und endohedraler Fullerene zur nachträglichen Beschichtung eines Substrats ist hier nicht notwendig.

Die Erfindung wird anhand des folgenden Ausführungsbeispiels, das die Herstellung von Li@$C_{60}$ beschreibt, näher ausgeführt.

Dabei zeigen:

Fig. 1 schematisch den apparativen Aufbau für die Durchführung des Verfahrens, wenn das Aufbringen eines Films von Fullerenen oder Fullerenderivaten und die Bestrahlung mit niederenergetischen Ionen nacheinander erfolgt;

Fig. 2 schematisch den apparativen Aufbau für die Durchführung des Verfahrens, wenn das Aufbringen von Fullerenen oder Fullerenderivaten und die Bestrahlung mit niederenergetischen Ionen gleichzeitig erfolgt;

Fig. 3 die Abhängigkeit des Verhältnisses der Anzahl eingeschlossener $Li^+$-Ionen pro Fläche zur Anzahl der $C_{60}$-Fullerene pro Fläche von der Ionenenergie;

Fig. 4 die Abhängigkeit des Verhältnisses der Anzahl eingeschlossener $Li^+$-Ionen pro Fläche zur Anzahl der $C_{60}$-Fullerene pro Fläche von der Anzahl auftreffender $Li^+$-Ionen pro $C_{60}$-Fullerenmolekül im Target;

Fig. 5 das Massenspektrum zum Nachweis der endohedralen Lithium-Fullerene (Li@$C_{60}$, Masse 727) in einem bestrahlten Fullerentarget ($C_{60}$, Masse 720).

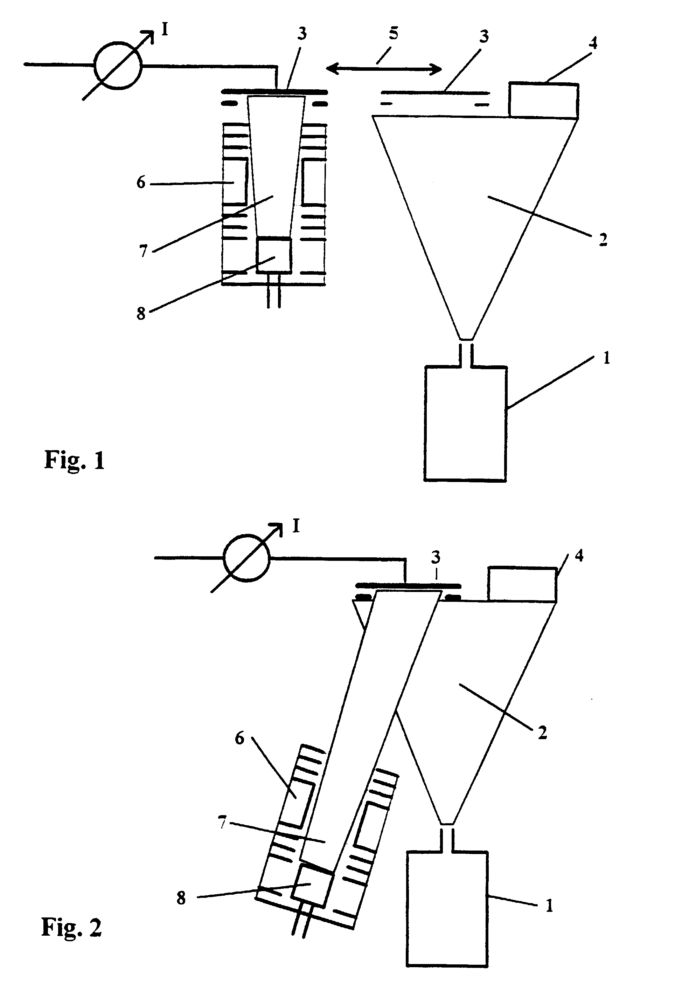

Die Figur 1 zeigt für die Durchführung des erfindungsgemäßen Verfahrens, bei dem das Aufbringen eines Films von Fullerenen oder Fullerenderivaten und die Bestrahlung mit niederenergetischen Ionen nacheinander erfolgt, schematisch den Aufbau einer Vakuumapparatur. Aus einem Fullerenofen **1** werden Fullerene oder Fullerenderivate **2** auf ein Target **3** gedampft. Die Dicke des $C_{60}$-Films wird mit einem Schichtdickenmeßgerät **4** bestimmt und die Menge der aufgebrachten

$C_{60}$-Moleküle ermittelt. Nachdem das Target **3** mit einer $C_{60}$-Fullerenschicht definierter Dicke bedeckt ist, wird dieses mit Hilfe eines Verschiebemechanismus **5** vor die Ionenoptik **6** bewegt und mit einem niederenergetischen $Li^+$-Ionenstrahl **7** bestrahlt, wobei die Werte des an die Ionenquelle **8** anzulegenden Potentials - und somit die Ionenenergie - und der Bestrahlungsdosis, bei denen das Verhältnis der Anzahl endohedraler Fullerene bzw. Fullerenderivate pro Fläche zur Anzahl der Fullerene bzw. Fullerenderivate pro Fläche am größten ist, vorab in Meßreihen ermittelt worden sind.

Die Energie der auf das Target 3 auftreffenden $Li^+$-Ionen **7** ist dadurch regelbar, daß an die Ionenquelle **8** unterschiedliche Potentiale angelegt werden. Der auf das Target 3 fallende Ionenstrom **I** wird gemessen und daraus die Bestrahlungsdosis (Anzahl der auftreffenden Ionen pro Fläche und Zeiteinheit) berechnet.

Die in Figur 2 dargestellte Apparatur ist für das gleichzeitige Aufbringen von Fullerenen oder Fullerenderivaten auf ein Target und Bestrahlen dieses Targets mit niederenergetischen Ionen geeignet. Es ist gezeigt, daß sowohl der Strahl **2** der aus dem Fullerenofen **1** auf das Target **3** aufzudampfenden Fullerene oder Fullerenderivate und der von der Ionenquelle **8** ausgehende Ionenstrahl **7** gleichzeitig auf das an einem festen Ort positionierte Target **3** gerichtet sind. Das Verhältnis der Anzahl $Li@C_{60}$ pro Fläche zur Anzahl der $C_{60}$-Fullerene pro Fläche ergibt sich wieder aus der Abscheiderate der Fullerene, gemessen mit dem Schichtdickenmeßgerät **4**, und dem Ionenstrom **I**, gemessen am Target **3**, bei Kenntnis der Meßreihen, die die Abhängigkeit des o.g. Verhältnisses von der Ionenenergie und/oder der Bestrahlungsdosis wiedergeben.

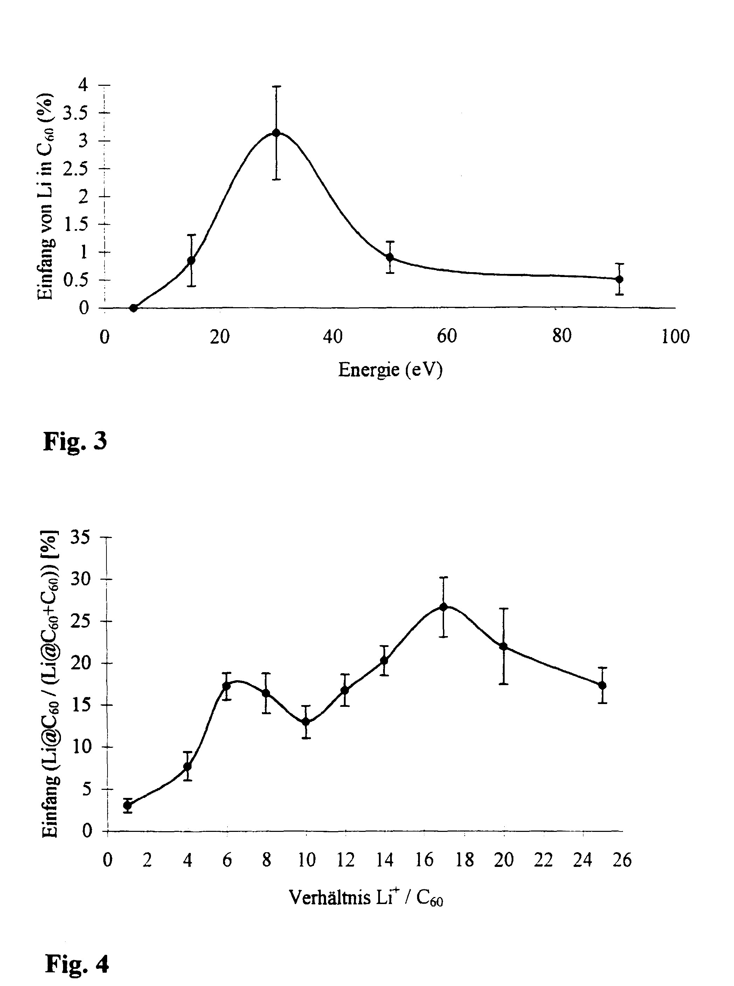

Figur 3 zeigt die graphische Darstellung einer solchen Meßreihe für Lithium, mit der die optimale Ionenenergie $E_{opt}$ für die Herstellung von $Li@C_{60}$ aufgefunden wurde. Die Energie, bei der am meisten $Li@C_{60}$ hergestellt wird, beträgt $E_{opt} = 30$ eV.

Die gleichen Meßreihen wurden auch für die Bestrahlung mit $Na^+$-, $K^+$-, $Rb^+$- und $Cs^+$-Ionen ermittelt und ergaben folgende optimale Ionenenergien $E_{opt}$, bei denen die größte Menge der entsprechenden endohedralen Fullerene hergestellt wurde:

$$Na@C_{60} \rightarrow E_{opt} = 70 \text{ eV};$$

$$K@C_{60} \rightarrow E_{opt} = 90 \text{ eV};$$

$$Rb@C_{60} \rightarrow E_{opt} = 100 \text{ eV};$$

$$Cs@C_{60} \rightarrow E_{opt} = 120 \text{eV}.$$

Figur 4 zeigt die graphische Darstellung der Abhängigkeit der Ausbeute, d.h. Verhältnis der Anzahl

der entstandenen $Li@C_{60}$ zur Gesamtzahl der auf dem Target vorhandenen Fullerene ($Li@C_{60}$ und $C_{60}$) pro Fläche, von dem Verhältnis $Li^+$-Ionen zu $C_{60}$-Molekülen pro Fläche. Mit dieser Meßreihe erfolgt eine weitere Optimierung der Einfangrate, hier nun durch Variation der Bestrahlungsdosis mit $Li^+$-Ionen. Bis zu 27% der bestrahlten $C_{60}$-Fullerenmoleküle werden in dem erfindungsgemäßen Verfahren in $Li@C_{60}$ umgewandelt.

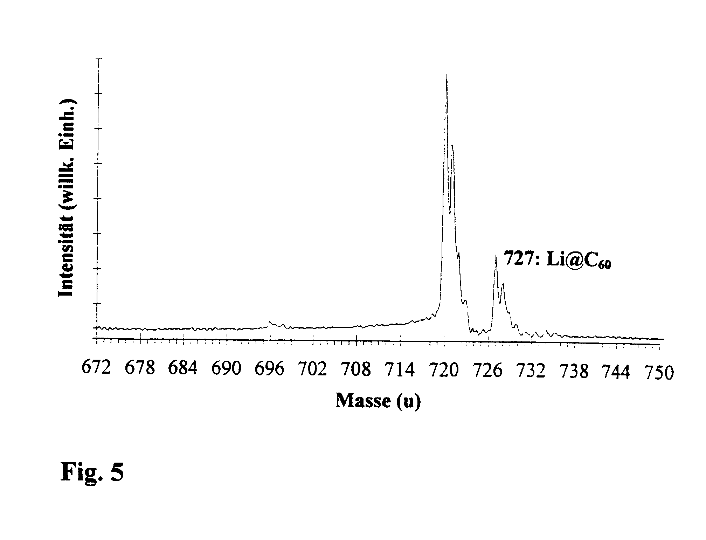

Der Nachweis dieser Umwandlung erfolgt mittels Laserdesorptions-Massenspektroskopie. In Figur 5 ist ein solches Spektrum für nach dem erfindungsgemäßen Verfahren hergestellte $Li@C_{60}$-Fullerene dargestellt. Die auf dem Target **3** aufgebrachte $C_{60}$-Schicht ist hierbei insgesamt 300 Å dick. Jeweils nach Aufbringen einer Monolage $C_{60}$ wurde diese mit $Li^+$-Ionen mit einer kinetischen Energie von 30eV bestrahlt. Im Zusammenhang mit der in Figur 4 graphisch dargestellten Meßreihe wird die höchste Einfangrate für $Li@C_{60}$ bei einem Ionen/Targetverhältnis ($Li^+$ : $C_{60}$) von 17 : 1 ermittelt.

## Patentansprüche

1. Verfahren zur Herstellung endohedraler Fullerene oder Fullerenderivate, bei dem Fullerene oder Fullerenderivate auf ein Target aufgebracht und in der festen Phase mit niederenergetischen Ionen einer kinetischen Energie zwischen 5 eV und 500 eV der einzubauenden Dotanten bestrahlt werden.

2. Verfahren nach Anspruch 1,
   **dadurch gekennzeichnet, daß**

   zunächst ein Film von Fullerenen oder Fullerenderivaten auf ein Target aufgedampft und gleichzeitig die Dicke des aufgedampften Films gemessen wird,
   anschließend der Film von Fullerenen oder Fullerenderivaten definierter Dicke mit einem Ionenstrahl mit einer über das an die Ionenquelle angelegte Potential regelbaren Ionenenergie und mit einer Bestrahlungsdosis, bei der die meisten Ionen der jeweiligen Dotanten in die Fullerene oder Fullerenderivate eingeschlossen werden, bestrahlt wird.

3. Verfahren nach Anspruch 2,
   **dadurch gekennzeichnet, daß**

   die Verfahrensschritte Aufdampfen eines Films von Fullerenen oder Fullerenderivaten und Bestrahlen dieses Films mit einem niederenergetischen Ionenstrahl mehrmals wiederholt werden.

4. Verfahren nach Anspruch 1,
   **dadurch gekennzeichnet, daß**

gleichzeitig sowohl Fullerene oder Fullerenderivate auf ein Target aufgedampft, als auch mit einem Ionenstrahl mit einer über das an die Ionenquelle angelegte Potential regelbaren Ionenenergie und mit einer Bestrahlungsdosis, bei der die meisten Ionen der jeweiligen Dotanten in die Fullerene oder Fullerenderivate eingeschlossen werden, bestrahlt werden und die Dicke der aufgedampften Schicht gemessen wird.

5. Verfahren nach mindestens einem der vorangehenden Ansprüche,
**dadurch gekennzeichnet, daß**

die Energie der Ionen, bei der die meisten Ionen der jeweiligen Dotanten in die Fullerene oder Fullerenderivate eingeschlossen werden, durch Variation des an der Ionenquelle anliegenden Potentials derart ermittelt wird, daß zunächst für ein Potential der Ionenquelle der auf das Target fallende Ionenstrom gemessen wird, daraus die Bestrahlungsdosis (Anzahl der auftreffenden Ionen pro Fläche und Zeiteinheit) errechnet wird, danach das Verhältnis der Anzahl endohedraler Fullerene bzw. Fullerenderivate pro Fläche zur Anzahl der Fullerene bzw. Fullerenderivate pro Fläche bestimmt wird und dieses Verhältnis für verschiedene Potentiale der Ionenquelle bei konstanter Bestrahlungsdosis ermittelt wird und abschließend das Potential der Ionenquelle zur Bestrahlung der Fullerene oder Fullerenderivate ausgewählt wird, bei dem das Verhältnis der Anzahl endohedraler Fullerene bzw. Fullerenderivate pro Fläche zur Anzahl der Fullerene bzw. Fullerenderivate pro Fläche am größten ist.

6. Verfahren nach mindestens einem der Ansprüche 1 bis 4,
**dadurch gekennzeichnet, daß**

die Bestrahlungsdosis, bei der die meisten Ionen der jeweiligen Dotanten in die Fullerene oder Fullerenderivate eingebaut werden, derart bestimmt wird, daß durch Variation der Bestrahlungsdosis bei optimierter Ionenenergie das jeweilige Verhältnis der Anzahl endohedraler Fullerene bzw. Fullerenderivate pro Fläche zur Anzahl der Fullerene oder Fullerenderivate pro Fläche bestimmt wird und abschließend die Bestrahlungsdosis bei optimiertem Potential der Ionenquelle zur Bestrahlung der Fullerene oder Fullerenderivate ausgewählt wird, bei der das Verhältnis der Anzahl endohedraler Fullerene bzw. Fullerenderivate pro Fläche zur Anzahl der Fullerene bzw. Fullerenderivate pro Fläche am größten ist.

7. Verfahren nach Anspruch 5 oder 6,
**dadurch gekennzeichnet, daß**

das Verhältnis der Anzahl endohedraler Fullerene bzw. Fullerenderivate pro Fläche zur Anzahl der Fullerene oder Fullerenderivate pro Fläche mittels Laserdesorptions-Massenspektrometrie ermittelt wird.

**Claims**

1. Method for preparing endohedral fullerenes or fullerene derivatives, in which method fullerenes or fullerene derivatives are deposited on a target and irradiated in the solid phase with low-energy ions, having a kinetic energy between 5 eV and 500 eV, of the dopants to be embedded.

2. Method according to claim 1, characterised in that first of all, a film of fullerenes or fullerene derivatives is vapour deposited onto a target and the thickness of the vapour-deposited film is measured simultaneously, and the film of fullerenes or fullerene derivatives of defined thickness is subsequently irradiated with an ion beam with an ionic energy which can be regulated by way of the potential applied to the ion source and with an irradiation dose at which most of the ions of the respective dopants are enclosed in the fullerenes or fullerene derivatives.

3. Method according to claim 2, characterised in that the method steps of vapour depositing a film of fullerenes or fullerene derivatives and irradiating this film with a low-energy ion beam are repeated a plurality of times.

4. Method according to claim 1, characterised in that fullerenes or fullerene derivatives are vapour deposited onto a target and simultaneously also irradiated with an ion beam with an ionic energy which can be regulated by way of the potential applied to the ion source and with an irradiation dose at which most of the ions of the respective dopants are enclosed in the fullerenes or fullerene derivatives, and the thickness of the vapour-deposited layer is measured.

5. Method according to at least one of the preceding claims, characterised in that the energy of the ions at which most of the ions of the respective dopants are enclosed in the fullerenes or fullerene derivatives is established by varying the potential at the ion source, in such a way that first of all a measurement is made for a potential of the ion source of the ionic current which falls on the target, from this the irradiation dose (number of ions which impact per area and unit of time) is calculated, then the ratio of the number of endohedral fullerenes or fullerene derivatives per area to the number of fullerenes or fullerene derivatives per area is determined and this ratio is established for different potentials of the ion source in the case of a constant irradiation dose, and subsequently the potential of the ion source for irradiation of the fullerenes or fullerene derivatives at which the ratio of the number of endohedral fullerenes or fullerene derivatives per area to the number of fullerenes or fullerene derivatives per area is the greatest is selected.

6. Method according to at least one of claims 1 to 4, characterised in that the irradiation dose at which most of the ions of the respective dopants are embedded in the fullerenes or fullerene derivatives is determined in such a way that by varying the irradiation dose in the case of optimised ionic energy, the respective ratio of the number of endohedral fullerenes or fullerene derivatives per area to the number of fullerenes or fullerene derivatives per area is determined, and subsequently the irradiation dose in the case of optimised potential of the ion source for irradiation of the fullerenes or fullerene derivatives at which the ratio of the number of endohedral fullerenes or fullerene derivatives per area to the number of fullerenes or fullerene derivatives per area is the greatest is selected.

7. Method according to claim 5 or 6, characterised in that the ratio of endohedral fullerenes or fullerene derivatives per area to the number of fullerenes or fullerene derivatives per area is established by means of laser-desorption mass spectrometry.

**Revendications**

1. Procédé de préparation de fullérènes endohédrales ou de dérivés de fullérènes endohédrales caractérisé en ce que

on met des fullérènes ou des dérivés de fullérènes sur une cible et on les irradie en phase solide par des ions à basse énergie ayant une énergie cinétique comprise entre 5eV et 500 eV des dotations à réaliser.

2. Procédé selon la revendication 1, caractérisé en ce que

on métallise sous vide tout d'abord un film de fullérènes ou de dérives de fullérènes sur une cible, et on mesure en même temps l'épaisseur du film métallisé sous vide, ensuite on irradie le film de fullérènes ou de dérivés de fullérènes ayant une épaisseur définie, par un rayonnement ionisant ayant une énergie ionisante réglable en fonction du potentiel appliqué à la source d'ions et avec une dose de rayonnement lors de laquelle la plupart des ions des dotations respectives sont enfermés dans les fullérènes ou les dérivés de fullérènes.

3. Procédé selon la revendication 2, caractérisé en ce qu'

on répète plusieurs fois les séquences du procédé, à savoir la métallisation sous vide d'un film de fullérènes ou de dérivés de fullérènes, et l'irradiation de ce film par un rayonnement ionisant à basse énergie.

4. Procédé selon la revendication 1, caractérisé en ce qu'

en même temps on métallise sous vide des fullérènes ou des dérivés de fullérènes sur une cible, et on les irradie avec un rayonnement ionisant ayant une énergie ionisante réglable en fonction du potentiel appliqué à la source d'ions, et avec une dose de rayonnement dans laquelle la plupart des ions des dotations respectives sont enfermés dans les fullérènes ou les dérivés de fullérènes, puis on mesure l'épaisseur de la couche métallisée sous vide.

5. Procédé selon au moins l'une des revendications précédentes, caractérisé en ce que

l'énergie des ions pour laquelle la plupart des ions des dotations respectives sont enfermés dans la fullérène ou le dérivé de fullérène, est déterminée en faisant varier le potentiel appliqué à la source d'ions d'une manière telle que tout d'abord on mesure le flux d'ions qui tombe sur la cible pour un potentiel donné de la source d'ions, on calcule à partir de là la dose d'irradiation (nombre des ions incidents par unité de surface et par unité de temps), on détermine ensuite le rapport entre le nombre de fullérènes ou de dérivés de fullérènes endohédrales par unité de surface et le nombre de fullérènes ou de dérivés de fullérènes par unité de surface, et l'on détermine ce rapport pour différents potentiels de la source d'ions à dose constante d'irradiation, et finalement on choisit le potentiel de la source d'ions irradiant la fullérène ou le dérivé de fullérène, pour lequel le rapport entre le nombre de fullérènes ou de dérivés de fullérènes endohédrales par unité de surface et le nombre de fullérènes ou de dérivés de fullérènes par unité de surface, est le plus grand.

6. Procédé selon au moins l'une des revendications 1 à 4,
caractérisé en ce que

la dose d'irradiation pour laquelle la plupart des ions de la dotation correspondante sont incorporés dans la fullérène ou dans le dérivé de fullérène, est déterminée d'une manière telle que l'on détermine le rapport correspondant entre le nombre de fullérènes ou de dérivés de fullérènes endohédrales par unité de surface, et le nombre de fullérènes ou de dérivés de fullérènes par unité de surface, en faisant varier la dose d'irradiation en optimisant l'énergie des ions, et ensuite on choisit la dose d'irradiation par optimisation du potentiel de la source d'ions irradiant la fullérène ou le dérivé de fullérène, pour laquelle le rapport entre le nombre de fullérènes ou de dérivés de fullérènes endohédrales par unité de surface et le nombre de fullérènes ou de dérivés de fullérènes par unité de surface, est le plus grand.

7. Procédé selon la revendication 5 ou la revendication 6,
caractérisé en ce qu'

on détermine le rapport entre le nombre de fullérènes ou de dérivés de fullérènes endohédrales par unité de surface et le nombre de fullérènes ou de dérivés de fullérènes par unité de surface, au moyen d'une spectrométrie de masse à désorption par laser.

Fig. 1

Fig. 2

**Fig. 3**

**Fig. 4**

**Fig. 5**